# EUROPÄISCHE PATENTSCHRIFT

(11) **EP 0 464 021 B1**
(45) Veröffentlichungstag und Bekanntmachung des Hinweises auf die Patenterteilung: **18.08.1993**
(21) Anmeldenummer: 89903690.9
(22) Anmeldetag: 22.03.1989
(51) Int. Cl.: G01R 15/06

(54) **MESSEINRICHTUNG MIT EINER HILFSELEKTRODE FÜR EINE GASISOLIERTE GEKAPSELTE HOCHSPANNUNGSANLAGE**
MEASURING DEVICE WITH AUXILIARY ELECTRODE FOR A GAS-INSULATED, ENCASED HIGH-VOLTAGE INSTALLATION
DISPOSITIF DE MESURE A ELECTRODE AUXILIAIRE POUR INSTALLATIONS A HAUTE TENSION BLINDEES ISOLEES AU GAZ

(43) Veröffentlichungstag der Anmeldung: 08.01.1992
(73) Patentinhaber: SIEMENS AKTIENGESELLSCHAFT, 80333 München (DE)
(72) Erfinder: GORABLENKOW, Jörg, W-1000 Berlin 20 (DE)
(86) Internationale Anmeldenummer: DE8900190
(87) Internationale Veröffentlichungsnummer: WO9011530

(56) Entgegenhaltungen:
- EP-A- 0 134 187
- DE-A- 3 121 795
- FR-A- 2 240 454
- US-A- 3 835 353

## Beschreibung

Die Erfindung bezieht sich auf eine Meßeinrichtung mit einer isoliert in einem rohrförmigen Ansatz auf der Mantelfläche der Kapselung einer gasisolierten, gekapselten Hochspannungsanlage angeordneten Hilfselektrode, die einerseits mit dem isoliert in der Kapselung angeordneten Innenleiter der Hochspannungsanlage den Oberspannungskondensator eines kapazitiven Spannungsteilers bildet und andererseits über einen Unterspannungskondensator mit der Kapselung verbunden ist, und die über einen mittels einer Durchführung gasdicht aus dem Ansatz herausgeleiteten Meßanschluß an ein Anzeige- oder Meßgerät angeschlossen ist, wobei der Unterspannungskondensator aus zwei ineinander verschachtelten und einen Abstand zueinander aufweisenden Kegeln gebildet ist, von denen der eine Kegel als Außenkegel und der andere Kegel als Innenkegel geformt ist.

Aus der EP 0 134 187 A 3 ist eine derartige Meßvorrichtung zur Feststellung von Teilentladungen in Hochspannungsschaltanlagen mit einem kapazitiven Spannungsteiler bekannt, bei dem eine Anordnung von ineinander verschachtelten Innenkegeln und Außenkegeln zur Anpassung des Wellenwiderstandes eines Meßkabels an die Meßvorrichtung dient. Dadurch sollen Signalreflexionen an dem Meßanschluß vermieden werden.

Eine Meßeinrichtung für eine gasisolierte gekapselte Hochspannungsanlage, insbesondere eine mit SF₆ druckgasisolierte, metallgekapselte Hochspannungsschaltanlage, ist aus der DE-AS 23 41 073 bekannt. Mit der bekannten, nach Art eines kapazitiven Spannungsteilers arbeitenden Meßeinrichtung wird die Spannung eines Innenleiters der gekapselten Hochspannungsanlage gemessen, wobei der Innenleiter als Teil des Oberspannungskondensators verwendet wird. Die zu dieser Messung der anliegenden Betriebsspannung verwendete Hilfselektrode, die in einen rohrförmigen Ansatz der Kapselung eingesetzt ist, der seinerseits durch einen Deckel verschlossen ist, hat aus Gründen der Meßgenauigkeit bei der Betriebsfrequenz verhältnismäßig große Abmessungen.

Ausgehend vom Stand der Technik liegt der vorliegenden Erfindung die Aufgabe zugrunde, eine Meßeinrichtung der eingangs genannten Art mit einer Hilfselektrode zur Spannungsmessung bei gekapselten druckgasisolierten Hochspannungsanlagen so auszubilden, daß sie einerseits eine hohe Eigenresonanzfrequenz aufweist und entsprechend eine sehr hohe obere Grenzfrequenz für die zu messenden Spannungen zuläßt und andererseits auch eine Messung der betriebsfrequenten Wechselspannung ermöglicht.

Zur Lösung dieser Aufgabe ist eine derartige Meßeinrichtung gemäß der Erfindung so ausgebildet, daß der Zwischenraum zwischen Innenkegel und Außenkegel durch ein festes Dielektrikum mit auch bei hohen Frequenzen gleichbleibender Dielektrizitätskonstante ausgefüllt ist, daß der mit der Hilfselektrode verbundene Außenkegel über einen Abschlußwiderstand mit dem Innenleiter eines gasdichten koaxialen Steckers für einen abgeschirmten Meßanschluß verbunden ist, wobei der Abschlußwiderstand dem Wellenwiderstand des koaxialen Steckers und/oder dem des abgeschirmten Meßanschlusses angepaßt ist, und daß die Kontaktfläche des Steckers für die Abschirmung des Meßanschlusses galvanisch mit der Kapselung und dem Innenkegel verbunden ist.

Hierbei wird unter einem Außenkegel (Innenkegel) ein Kegel verstanden, dessen Außenfläche (Innenfläche) kegelig ist.

Der Aufbau des Unterspannungskondensators aus zwei ineinander verschachtelten Kegeln ergibt mit dem Tragkörper eine extrem gedrängte zylindrische Anordnung. Die kegelförmige Ausbildung des Unterspannungskondensators verhindert auch elektrische Schwingungen, wie sie bei plattenförmigen Elektroden eines Kondensators auftreten können. Die Eigenresonanzfequenz dieser Anordnung ist daher sehr groß und läßt für die gewünschten Messungen der hochfrequenten Ausgleichsvorgänge, die z. B. durch Schaltvorgänge innerhalb der Anlage hervorgerufen werden, eine entsprechend hohe obere Grenzfrequenz zu, z. B. im Bereich von angenährt 1 GHz. Die Dicke des zwischen dem Innenkegel und dem Außenkegel angeordneten festen Dielektrikums läßt sich außerdem genügend klein wählen, um trotz des geringen Außendurchmessers einen für die Messung der betriebsfrequenten Wechselspannung mit hochohmigen Meßverstärkern genügend großen Kapazitätswert des Unterspannungskondensators zu realisieren.

Der kegelförmige verschachtelte Aufbau des Unterspannungskondensators ergibt weiterhin in Verbindung mit dem koaxialen gasdichten Stecker für den abgeschirmten Meßanschluß einen zylindrischen koaxialen, völlig abgeschirmten Aufbau der gesamten Meßeinrichtung mit integriertem Dämpfungswiderstand (Abschlußwiderstand), der dem Wellenwiderstand des koaxialen Steckers und/oder dem des abgeschirmten Meßanschlusses angepaßt ist. Die Meßeinrichtung kann aufgrund dieses konstruktiven Aufbaus mit geringen Außenabmessungen auch nachträglich an beliebigen Stellen einer bereits in Betrieb befindlichen gekapselten gasisolierten Hochspannungsanlage eingebaut werden, z. B. in einem bereits für einen Gasanschluß vorhandenen rohrförmigen Ansatz.

Es empfiehlt sich, einen Tragkörper vorzusehen, der beide Kegel miteinander verspannt und außerdem den galvanischen Kontakt sowohl zum Außenleiter, d. h. der äußeren Kontaktfläche, des koaxialen Steckers als auch zur Kapselung herstellt. Eine einfache Fertigung und Montage ergibt sich, wenn als Tragkörper eine auf einen Adapter und den Außenkegel aufgeschraubte Überwurfmutter dient, wobei der Adapter den koaxialen Stecker gasdicht trägt und ebenfalls gasdicht mit dem rohrförmigen Ansatz verbunden ist.

Da der in der Meßeinrichtung verwendete koaxiale Stecker, dessen Innenleiter über den Abschlußwiderstand mit dem Außenkegel und dessen Außenleiter galvanisch mit der Kapselung verbunden ist, bereits ein gasdichtes Bauteil bildet, wird somit die Gasdichtigkeit der gesamten Meßeinrichtung gegenüber dem rohrförmigen Ansatz dadurch hergestellt, daß auch zwischen diesem und dem Adapter eine Gasdichtung angeordnet ist. Diese Gasdichtung kann mit Vorteil aus zwei über eine mittige Scheibe verbundene und hintereinander geschalteten Gasdichtungsringen bestehen, damit durch eine Veränderung der Höhe der Scheibe die Eindringtiefe der Hilfselektrode in den Innenraum der Kapselung variierbar ist. Dadurch kann man die Kapazität des Oberspannungskondensators des kapazitiven Spannungsteilers und somit das Teilerverhältnis verändern.

Eine vorteilhafte Ausgestaltung der erfindungsgemäßen Meßeinrichtung sieht vor, daß die Kegelflächen des Innen- und des Außenkegels entgegengesetzt gleich große Neigungen aufweisen.

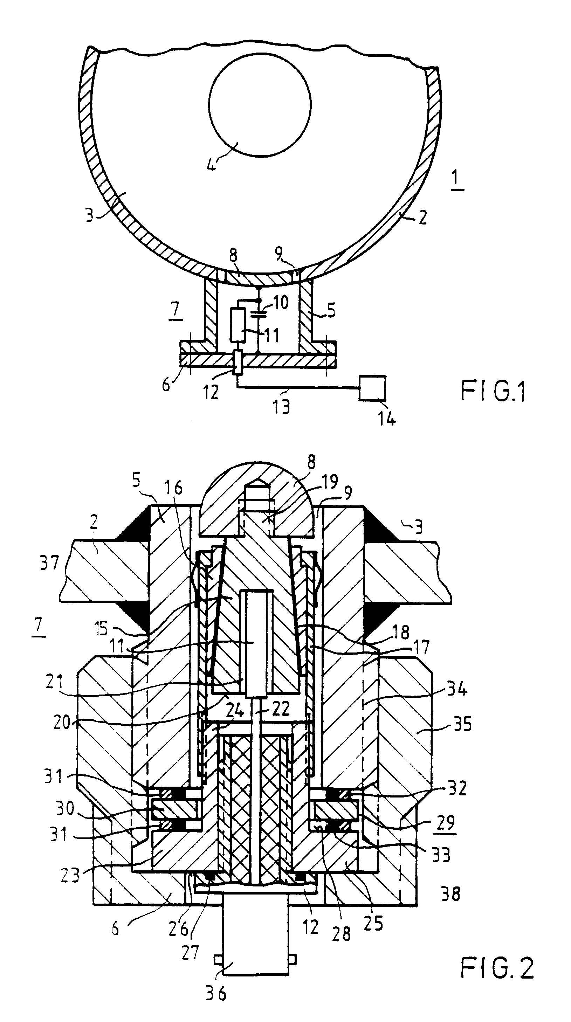

Im folgenden sei die Erfindung anhand des in den Figuren 1 und 2 der Zeichnung dargestellten Ausführungsbeispiels, auf welches sich die Erfindung aber nicht beschränkt, noch näher erläutert.

Figur 1 zeigt eine schematische Darstellung der gasisolierten, gekapselten Hochspannungsanlage mit der Meßeinrichtung. In Figur 2 ist, ebenfalls schematisch, ein Längsschnitt durch die Meßeinrichtung dargestellt.

Eine gasisolierte, gekapselte Hochspannungsanlage 1 weist eine geerdete, metallische Kapselung 2 auf, in deren mit Druckgas, z. B. SF₆ gefülltem Innenraum 3 ein Innenleiter 4 angeordnet ist. Dieser Innenleiter 4 führt ein Hochspannungspotential und ist gegenüber der geerdeten Kapselung 2 durch nicht dargestellte Stützisolatoren auf Abstand gehalten.

An der Kapselung 2 ist außerdem ein rohrförmiger Ansatz 5 angeordnet, der durch einen Deckel 6 gasdicht verschlossen ist. In diesem Ansatz 5 ist die gemäß der Erfindung ausgebildete Meßeinrichtung 7 mit einer Hilfselektrode 8 untergebracht, derart, daß die Hilfselektrode 8 die Durchtrittsöffnung 9 zwischen der Kapselung 2 und dem Ansatz 5 weitgehend abdeckt, aber dennoch durch das in dem verbleibenden Spalt befindliche Gas gegenüber der Kapselung 2 isoliert ist.

Die Hilfselektrode 8 bildet einerseits mit dem isoliert in der Kapselung 2 angeordneten Innenleiter 4 der Hochspannungsanlage 1 den Oberspannungskondensator eines kapazitiven Spannungsteilers und ist andererseits über einen Unterspannungskondensator 10 mit der Kapselung 2 verbunden, d. h. der eine Anschluß des Unterspannungskondensators 10 liegt auf Erdpotential. Mit Hilfe der Meßeinrichtung 7 kann die am Innenleiter 4 auftretende Spannung erfaßt werden und die Meßwerte werden über einen Abschlußwiderstand 11 und einem als Durchführung durch den Deckel 6 des Ansatzes 5 ausgebildeten koaxialen, gasdichten Stecker 12 zum Außenraum geleitet, wo sie mit Hilfe eines abgeschirmten Meßanschlusses 13 mit hochohmigem Eingangswiderstand einem Anzeige- oder Meßgerät 14, z. B. einem Oszilloskop, zugeführt werden.

Damit durch die Meßeinrichtung auch hochfrequente transiente Ausgleichsvorgänge erfaßt werden können, ist die Bauweise der Meßeinrichtung 7 sehr kompakt und raumsparend ausgeführt. Der konstruktive Aufbau der Meßeinrichtung 7 ergibt sich aus der Figur 2, in der für gleiche Teile gleiche Bezugszeichen beibehalten sind.

Die Hilfselektrode 8 ist halbkugelförmig ausgebildet und ragt etwas über die Durchtrittsöffnung 9 des rohrförmigen Ansatzes 5 in den Innenraum 3 der Kapselung hinein. Dadurch wird das elektrische Feld innerhalb der Kapselung 2 möglichst wenig durch die Hilfselektrode 8 gestört.

Der Unterspannungskondensator 10 mit der Unterspannungskapazität C_{N} ist aus zwei Kegeln 15, 16 gebildet, die als Innenkegel 16 und Außenkegel 15 geformt und ineinander verschachtelt sind und von einer den Innenkegel 16 umfassenden Überwurfmutter 17 zusammengespannt werden. Zwischen dem Innenkegel 16 und dem Außenkegel 15 des Unterspannungskondensators 10 ist als festes Dielektrikum 18 eine Polyester-folie angeordnet, deren Dielektrizitätskonstante auch bei hohen Frequenzen gleichbleibend ist.

Der Außenkegel 15 ist mit der Hilfselektrode 8 durch einen Schraubansatz 19 verbunden. In dem Außenkegel 15 ist eine zu der der Hilfselektrode 8 abgewandten Stirnseite 20 offene, mittige Aussparung 21 vorgesehen, in welcher der Abschlußwiderstand 11 liegt, der auf einer Seite mit dem Außenkegel 15 verbunden ist. Die andere Seite des Abschlußwiderstandes 11 ist direkt mit dem Innenleiter 22 des gasdichten, koaxialen Steckers 12 verbunden. Dieser Abschlußwiderstand 11 ist dem Wellenwiderstand des koaxialen Steckers 12 bzw. des abgeschirmten Meßanschlusses 13 angepaßt und verhindert somit als Dämpfungswiderstand elektrische Schwingungen mit der Kapazität des Meßanschlusses.

Als Tragkörper der Meßeinrichtung 7 dient außer der Überwurfmutter 17 ein Adapter 23, dessen rohrförmiger Teil 24 mit dem über die Stirnseite 20 des Innenkegels 15 hinausragenden Teil der Überwurfmutter 17 verschraubt ist. Dieser rohrförmige Teil 24 des Adapters 23 läuft zu einem Ringansatz 25 aus, gegen dessen äußere Stirnfläche 26 die Gasdichtung 27 des koaxialen Steckers 12, der in den Adapter 23 eingeschraubt ist, angepreßt ist. Auf der anderen Stirnfläche 28 des Ringansatzes 25 des Adapters 23 liegt die Gasdichtung 29 zwischen dem Adapter 23 und dem rohrförmigen Ansatz 5. Diese Gasdichtung 29 besteht aus zwei über eine mittige Scheibe 30 verbundene, hintereinander geschaltete Gasdichtungsringe 31. Dadurch kann durch Auswechseln der Scheibe 30 die Eintrittstiefe der Hilfselektrode 8 in den Innenraum 3 der Kapselung 2 eingestellt werden. Entsprechend ist die Kapazität des Oberspannungskondensators einstellbar und somit das Teilerverhältnis des kapazitiven Spannungsteilers beeinflußbar.

Die Gasdichtungringe 31 bestehen aus in einem Metallring 32 gehaltenem Dichtungsmaterial 33, wodurch außer dem gasdichten Abschluß auch eine galvanische Kontaktierung und somit eine Übertragung des Erdpotentials von dem Adapter 23 zum rohrförmigen Ansatz 5 erreicht wird.

Der für die Gasdichtung 29 erforderliche Anpreßdruck zwischen dem Adapter 23 und dem rohrförmigen Ansatz 5 der Kapselung 2 wird durch eine auf ein Außengewinde 34 des rohrförmigen Ansatzes 5 aufgeschraubte zweite Überwurfmutter 35 hervorgerufen, deren stirnseitiger Ansatz gegen die äußere Stirnfläche 26 des Adapters 23 gepreßt ist. Diese Überwurfmutter 35 wirkt somit wie ein Deckel 6 und verschließt den rohrförmigen Ansatz 5 bis auf den herausragenden koaxialen Stecker 12. Die äußere Kontaktfläche 36 des koaxialen Steckers 12 wird für die Messung mit der Abschirmung des Meßanschlusses 13 verbunden, sein Innenleiter 22 stellt den Kontakt zum Anzeige- oder Meßgerät 14 her.

Um elektrische Schwingungen zwischen dem Außenkegel 16 und der Kapselung 2 weitgehend zu unterdrücken, ist außerdem benachbart zur Hilfselektrode 8 ein zusätzlicher Kontakt 37 zwischen der Überwurfmutter 17 und dem rohrförmigen Ansatz 5 angeordnet. Dieser zusätzliche Kontakt 37 besteht aus einem Kontaktfederstreifen, der bei geringer Höhe eine gute Kontaktierung ergibt.

Durch den äußerst kompakten Aufbau der Meßeinrichtung 7 mit der Hilfselektrode 8 kann der Innendurchmesser des rohrförmigen Ansatzes 5 verhältnismäßig klein sein. Man kann somit bereits bei in Betrieb befindlichen gekapselten Hochspannungsanlagen vorhandene Gasanschlüsse als rohrförmigen Ansatz 5 ausnutzen. Durch die Verwendung einer dünnen Polyesterfolie für das Dielektrikum 18 bei dem Unterspannungskondensator 10 ist die Unterspannungskapazität C_{N} genügend groß, um bei der Frequenz der Betriebswechselspannung mit einem hochohmigen Verstärker eine Kalibrierung der Meßeinrichtung 7 bzw. Bestimmung des Teilerverhältnisses des kapazitiven Spannungsteilers vorzunehmen.

Außerdem weist die zweite Überwurfsmutter 35 ein Außengewinde 38 zum einfachen Anschluß einer zusätzlichen Abschirmung auf.

## Patentansprüche

1. Meßeinrichtung (7) mit einer isoliert in einem rohrförmigen Ansatz (5) auf der Mantelfläche der Kapselung (2) einer gasisolierten, gekapselten Hochspannungsanlage (1) angeordneten Hilfselektrode (8), die einerseits mit dem isoliert in der Kapselung (2) angeordneten Innenleiter (4) der Hochspannungsanlage (1) den Oberspannungskondensator eines kapazitiven Spannungsteilers bildet und andererseits über einen Unterspannungskondensator (10) mit der Kapselung (2) verbunden ist, und die über einen mittels einer Durchführung gasdicht aus dem Ansatz (5) herausgeleiteten Meßanschluß an ein Anzeige- oder Meßgerät (14) angeschlossen ist, wobei der Unterspannungskondensator (10) aus zwei ineinander verschachtelten und einen Abstand zueinander aufweisenden Kegeln (15, 16) gebildet ist, von denen der eine Kegel als Außenkegel (15) und der andere Kegel als Innenkegel (16) geformt ist,
**dadurch gekennzeichnet,** daß der Zwischenraum zwischen Innenkegel (16) und Außenkegel (15) durch ein festes Dielektrikum (18) mit auch bei hohen Frequenzen gleichbleibender Dielektrizitätskonstante ausgefüllt ist, daß der mit der Hilfselektrode (8) verbundene Außenkegel (15) über einen Abschlußwiderstand (11) mit dem Innenleiter (22) eines gasdichten koaxialen Steckers (12) für einen abgeschirmten Meßanschluß (13) verbunden ist, wobei der Abschlußwiderstand (11) dem Wellenwiderstand des koaxialen Steckers (12) und/oder dem des abgeschirmten Meßanschlusses (13) angepaßt ist, und daß die Kontaktfläche (36) des Steckers (12) für die Abschirmung des Meßanschlusses (13) galvanisch mit der Kapselung (2) und dem Innenkegel (16) verbunden ist.

2. Meßeinrichtung nach Anspruch 1,
**dadurch gekennzeichnet,** daß
eine über den Innenkegel (16) auf einen Adapter (23) aufgeschraubte Überwurfmutter (17) beide Kegel (15, 16) miteinander verspannt und daß der Adapter (23) den koaxialen Stecker (12) gasdicht trägt und ebenfalls gasdicht mit dem rohrförmigen Ansatz (5) verbunden ist.

3. Meßeinrichtung nach Anspruch 2,
**dadurch gekennzeichnet,** daß
die Gasdichtung (29) zwischen dem Adapter (23) und dem rohrförmigen Ansatz (5) aus zwei über eine mittige Scheibe (30) verbundenen, hintereinander geschalteten Gasdichtungsringen (31) besteht.

4. Meßeinrichtung nach Anspruch 2 oder 3,
**dadurch gekennzeichnet,** daß
die Gasdichtung (29) zwischen dem Adapter (23) und dem rohrförmigen Ansatz (5) auch einen galvanischen Kontakt herstellt.

5. Meßeinrichtung nach Anspruch 2 oder 3 oder 4,
**dadurch gekennzeichnet,** daß
eine auf einem Außengewinde (34) des rohrförmigen Ansatzes (5) aufgeschraubte zweite Überwurfsmutter (35) vorgesehen ist, deren stirnseitiges Mittelteil (6) gegen die Stirnfläche (26) des Adapters (23) gepreßt ist.

6. Meßeinrichtung nach einem der Ansprüche 1 bis 5,
**dadurch gekennzeichnet,** daß
der Abschlußwiderstand (11) in einer mittigen Aussparung (21) des Außenkegels (15) liegt.

7. Meßeinrichtung nach einem der Ansprüche 1 bis 4,
**dadurch gekennzeichnet,** daß
als festes Dielektrikum (18) eine Polyesterfolie verwendet ist.

8. Meßeinrichtung nach einem der Ansprüche 1 bis 7,
**dadurch gekennzeichnet,** daß die Hilfselektrode (8) halbkugelförmig gestaltet ist.

9. Meßeinrichtung nach Anspruch 1 bis 8,
**dadurch gekennzeichnet,** daß benachbart zur Hilfselektrode (8) ein zusätzlicher Kontakt (37) zwischen der Überwurfmutter (17) und den rohrförmigen Ansatz (5) angeordnet ist.

10. Meßeinrichtung nach Anspruch 9,
**dadurch gekennzeichnet,** daß der zusätzliche Kontakt (37) aus einem Kontaktfederstreifen besteht.

11. Meßeinrichtung nach Anspruch 1 bis 8,
**dadurch gekennzeichnet,** daß die Kegelflächen des Innen- und des Außenkegels entgegengesetzt gleich große Neigungen aufweisen.

## Claims

1. Measuring device (7) having an auxiliary electrode (8) arranged insulated in a tubular attachment (5) on the surface of the casing (2) of a gas-insulated, encased high-voltage installation (1), which auxiliary electrode on the one hand forms with the inner conductor (4) of the high-voltage installation (1) arranged insulated in the casing (2) the upper-voltage capacitor of a capacitive voltage divider and on the other hand is connected by way of a lower-voltage capacitor (10) to the casing (2), and which is attached to a display or measuring device (14) by way of a measuring terminal conducted out of the attachment (5) by means of a bushing in a gastight manner, whereby the lower-voltage capacitor (10) is formed from two cones (15, 16) inserted into one another and having a clearance from one another, one cone of which is formed as outer cone (15) and the other cone as inner cone (16),
characterized in that the intermediate space between inner cone (16) and outer cone (15) is filled by a fixed dielectric (18) with dielectricity constant which is constant even at high frequencies, in that the outer cone (15) connected to the auxiliary electrode (8) is connected by way of a terminating resistor (11) to the inner conductor (22) of a gastight coaxial plug (12) for a screened measuring terminal (13), whereby the terminating resistor (11) is adapted to the surge impedance of the coaxial plug (12) and/or that of the screened measuring terminal (13), and in that the contact face (36) of the plug (12) for screening the measuring terminal (13) is galvanically connected to the casing (2) and the inner cone (16).

2. Measuring device according to claim 1, characterized in that a screw cap (17) screwed by way of the inner cone (16) on to an adaptor (23) braces both cones (15, 16) with one another and in that the adaptor (23) carries the coaxial plug (12) in a gastight manner and is likewise connected in a gastight manner to the tubular attachment (5).

3. Measuring device according to claim 2, characterized in that the gas seal (29) between the adaptor (23) and the tubular attachment (5) consists of two series-connected gas sealing rings (31) connected by way of a central disc (30).

4. Measuring device according to claim 2 or 3, characterized in that the gas seal (29) between the adaptor (23) and the tubular attachment (5) also produces a galvanic contact.

5. Measuring device according to claim 2 or 3 or 4, characterized in that a second screw cap (35) screwed on an external thread (34) of the tubular attachment (5) is provided, the face centre part (6) of which is pressed against the face (26) of the adaptor (23).

6. Measuring device according to one of claims 1 to 5, characterized in that the terminating resistor (11) lies in a central recess (21) of the outer cone (15).

7. Measuring device according to one of claims 1 to 4, characterized in that a polyester film is used as fixed dielectric (18).

8. Measuring device according to one of claims 1 to 7, characterized in that the auxiliary electrode (8) is formed in the shape of a hemisphere.

9. Measuring device according to claim 1 to 8, characterized in that an additional contact (37) between the screw cap (17) and the tubular attachment (5) is arranged adjacent to the auxiliary electrode (8).

10. Measuring device according to claim 9, characterized in that the additional contact (37) consists of a contact-spring strip.

11. Measuring device according to claim 1 to 8, characterized in that the cone faces of the inner and the outer cone have opposed inclinations of the same size.

## Revendications

1. Dispositif de mesure (7) comportant une électrode auxiliaire (8), qui est disposée en étant isolée dans un embout tubulaire (5) sur la surface enveloppe du capot (2) d'une installation encapsulée à haute tension (1), isolée par un gaz, et qui d'une part forme avec le conducteur intérieur (4), installé d'une manière isolée dans le capot (2), de l'installation à haute tension (1), le condensateur à haute tension d'un diviseur de tension capacitif, et d'autre part est raccordé au capot (2) par l'intermédiaire d'un condensateur à basse tension (10), et qui est raccordée à un appareil indicateur ou un appareil de mesure (14) par l'intermédiaire d'une borne de mesure qui ressort d'une manière étanche aux gaz hors de l'embout (5) par l'intermédiaire d'une traversée, le condensateur à basse tension (10) étant formé par deux cônes (15,16) imbriqués l'un dans l'autre et distants l'un de l'autre et dont l'un est conformé en cône extérieur (15) et dont l'autre est conformé en cône intérieur (16),
caractérisé par le fait que l'espace intermédiane entre le cône intérieur (16) et le cône extérieur (15) est rempli par un diélectrique solide (18) possédant une constante diélectrique qui est constante même à des fréquences élevées, que le cône extérieur (15), qui est raccordé à l'électrode auxiliaire (8), est raccordé par l'intermédiaire d'une résistance de terminaison (11) au conducteur intérieur (22) d'un connecteur coaxial (12) étanche aux gaz, pour une borne de mesure blindée (13), la résistance de terminaison (11) étant adaptée à l'impédance caractéristique du connecteur coaxial (12) et/ou à l'impédance caractéristique de la borne de mesure blindée (13), et que la surface de contact (36) du connecteur (12) pour le blindage de la borne de mesure (13) est raccordée galvaniquement au capot (2) et au cône intérieur (16).

2. Dispositif de mesure suivant la revendication 1, caractérisé par le fait qu'un écrou-raccord (17) vissé par l'intermédiaire du cône intérieur (16) sur un adaptateur (23) serre l'un contre l'autre les deux cônes (15,16) et que l'adaptateur (23) porte, d'une manière étanche aux gaz, le connecteur coaxial (12) et est également raccordé, d'une manière étanche aux gaz, à l'embout tubulaire (5).

3. Dispositif de mesure suivant la revendication 2, caractérisé par le fait que le système d'étanchéité aux gaz (29) entre l'adaptateur (23) et l'embout tubulaire (5) est constitué par deux bagues d'étanchéité aux gaz (31), qui sont raccordées au moyen d'un disque médian (30) et sont montées l'une derrière l'autre.

4. Dispositif de mesure suivant la revendication 2 ou 3, caractérisé par le fait que le système d'étanchéité aux gaz (29) entre l'adaptateur (23) et l'embout tubulaire (5) établit également un contact galvanique.

5. Dispositif de mesure suivant la revendication 2 ou 3 ou 4, caractérisé par le fait qu'il est prévu un second écrou-raccord (35), qui est vissé sur un filetage extérieur (34) de l'embout tubulaire (5) et dont la partie centrale frontale (6) est repoussée contre la surface frontale (26) de l'adaptateur (23).

6. Dispositif de mesure suivant l'une des revendications 1 à 5, caractérisé par le fait que la résistance de terminaison (11) est située dans un évidement central (21) du cône extérieur (15).

7. Dispositif de mesure suivant l'une des revendications 1 à 4, caractérisé par le fait qu'on utilise une feuille de polyester en tant que diélectrique solide (18).

8. Dispositif de mesure suivant l'une des revendications 1 à 7, caractérisé par le fait que l'électrode auxiliaire (8) possède une forme hémisphérique.

9. Dispositif de mesure suivant l'une des revendications 1 à 8, caractérisé par le fait qu'un contact supplémentaire (37) est disposé au voisinage de l'électrode auxiliaire (8) entre l'écrou-raccord (17) et l'embout tubulaire (5).

10. Dispositif de mesure suivant la revendication 9, caractérisé par le fait que le contact supplémentaire (37) est constitué par une bande formant ressort de contact.

11. Dispositif de mesure suivant les revendications 1 à 8, caractérisé par le fait que les surfaces coniques du cône intérieur et du cône extérieur possèdent des inclinaisons identiques en des sens opposés.
